# EUROPEAN PATENT APPLICATION

(11) **EP 4 135 028 A1**
(43) Date of publication of application: **15.02.2023**
(21) Application number: 22184423.6
(22) Date of filing: 12.07.2022
(51) Int. Cl.: H01L 23/495

(54) **ELECTRONIC COMPONENT WITH MOULDED PACKAGE**

(30) Priority: 12.08.2021 FI 20215850
(71) Applicant: Murata Manufacturing Co., Ltd., Nagaokakyo-shi, Kyoto 617-8555 (JP)
(72) Inventor: Kaija, Kimmo, 02660 Espoo (FI)
(74) Representative: Boco IP Oy Ab

(57) **Abstract**

An electronic component comprising a plastic package and an electric chip which is inside the package. The electronic component comprises a metallic die pad and a metallic first support structure extends from the die pad to a first support point on one of the side surfaces of the plastic package. The electronic component also comprises a metallic opposing pad and a metallic second support structure which extends from the opposing pad to a second support point on one of the side surfaces of the plastic package.

## Description

### FIELD OF THE DISCLOSURE

This disclosure relates to electronic components, and particularly to packaged electronic components where a chip is attached to a mounting surface and then surrounded by a moulded housing.

### BACKGROUND OF THE DISCLOSURE

Electronic components are often prepared by manufacturing multiple chips on a substrate and then separating the chips from each other. Each chip can then be placed in a protective package which forms an enclosure where the chip is protected from the surrounding environment. The chip can be attached to a pad inside the enclosure and electrically connected to contact elements which extend outside of the enclosure. The chip, the package and the contact elements form an electronic component which can be mounted on a circuit board for use.

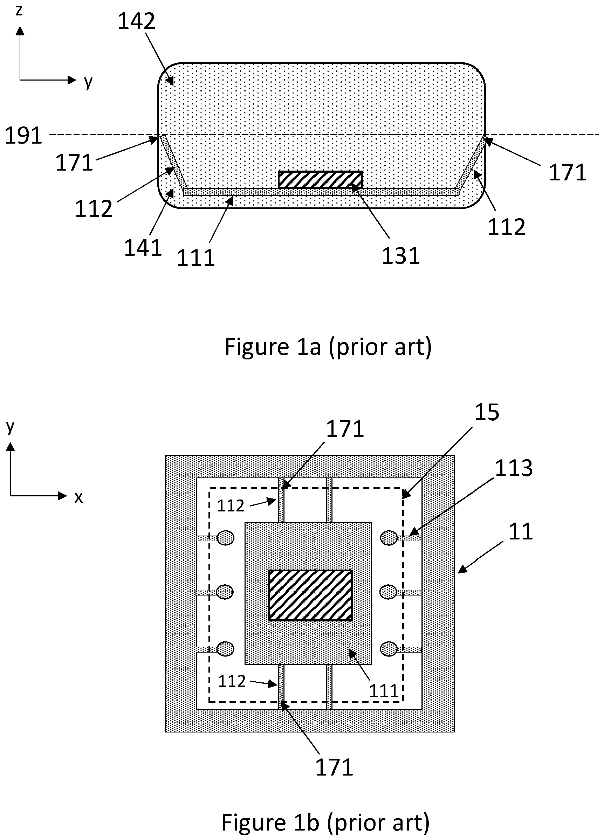

One way to package an electronic chip is to attach the chip to a die pad which has been formed from a malleable planar sheet, which may be called leadframe. Figure 1 a illustrates schematically an electronic component known from the prior art. The leadframe 11 can be patterned by etching and stamping methods so that it contains an area which will form a die pad 111 where the chip 131 can be mounted. The patterned leadframe 11 may also include one or more support structures 112 which allow the die pad 111 to be offset in the vertical direction from the plane of the leadframe 11. This plane is indicated as 191 in figure 1a. Contact elements 113 where the chip 131 can be electrically connected to the outside of the package may also be formed in the leadframe 11.

Figure 1b illustrates the leadframe plane. When the chip 131 has been attached and connected to the die pad 111, two halves 141 - 142 of a plastic package can be moulded onto opposite sides of the leadframe 11, for example so that sidewalls of the package are formed in the area which is indicated with dashed line 15 in figure 1b. The moulded package can then be released from the surrounding leadframe 11 by releasing the support structures 112 and contact elements 113 from the main part of the surrounding leadframe 11. The point where the support structure is released may be called a support point 171. The chip 131 which rests on the die pad 111 can thereby be enclosed inside the package walls of the electronic component. Contact elements 113 can extend through the package walls so that they can be connected to an electric circuit.

Documents US6818973 and US5157480 disclose electrical components where a leadframe has been used to form a die pad which is offset from the center of the component. A general problem with this arrangement is that the structures formed by the die pad and the support structures inside the component are asymmetric with respect to the center of the component. The package may be deformed by thermal stress due to this asymmetry and the differences in thermal expansion coefficients in the various parts of the component.

### BRIEF DESCRIPTION OF THE DISCLOSURE

An object of the present disclosure is to provide a method and an apparatus for alleviating the above disadvantages.

The object of the disclosure is achieved by a method and an arrangement which are characterized by what is stated in the independent claims. The preferred embodiments of the disclosure are disclosed in the dependent claims.

The disclosure is based on the idea of utilizing two leadframes stacked upon each other. A first leadframe contains a die pad while a second leadframe contains an opposing pad. The first and second leadframes are placed on top of each other so that the die pad and the opposing pad oppose each other. An advantage of this method and arrangement is that the pads and the support structures inside the component will be more symmetric and the component will therefore be less sensitive to thermal stress.

### BRIEF DESCRIPTION OF THE DRAWINGS

In the following the disclosure will be described in greater detail by means of preferred embodiments with reference to the accompanying drawings, in which
Figures 1a and 1b illustrate schematically an electronic component known from the prior art.
Figures 2a - 2f illustrate cross-sections of an electronic component which comprises a plastic package.
Figures 3a - 3b illustrate options for how the support planes, the die pad plane and the opposing pad plane may be ordered.
Figures 4a - 4b illustrate components with two chips.
Figures 5a - 5b illustrate other options for how the support planes, the die pad plane and the opposing pad plane may be ordered.
Figure 6 illustrates another option for how the support planes, the die pad plane and the opposing pad plane may be ordered.
Figure 7 illustrates exposed pads.
Figure 8 illustrates a method for manufacturing an electronic component.

### DETAILED DESCRIPTION OF THE DISCLOSURE

This disclosure describes an electronic component comprising a plastic package and an electric chip which is inside the package. The plastic package has a first surface and a second surface, and the first surface and second surface are opposite to each other in a vertical z-direction. The plastic package also has at least one side surface which extends between the first surface and the second surface.

The electronic component comprises a metallic die pad which defines a die pad plane which is substantially horizontal. A metallic first support structure extends from the die pad to a first support point on the at least one side surface of the plastic package. The first support structure is at least partly embedded within the plastic package. The z-coordinate of the first support point defines a horizontal first support plane. A first electric chip is attached to the die pad.

The electronic component also comprises a metallic opposing pad which defines an opposing pad plane which is substantially horizontal. A metallic second support structure extends from the opposing pad to a second support point on the at least one side surface of the plastic package. The second support structure is at least partly embedded within the plastic package. The z-coordinate of the second support point defines a horizontal second support plane.

The die pad may be formed in a first leadframe and the opposing pad may be formed in a second leadframe. As described in more detail below, the first and second leadframes may be placed on top of each other when the component is manufactured, and the component may be released from main parts of the first and second leadframes when the packaging has been completed. The main parts of the leadframe will therefore not form a part of the finished component.

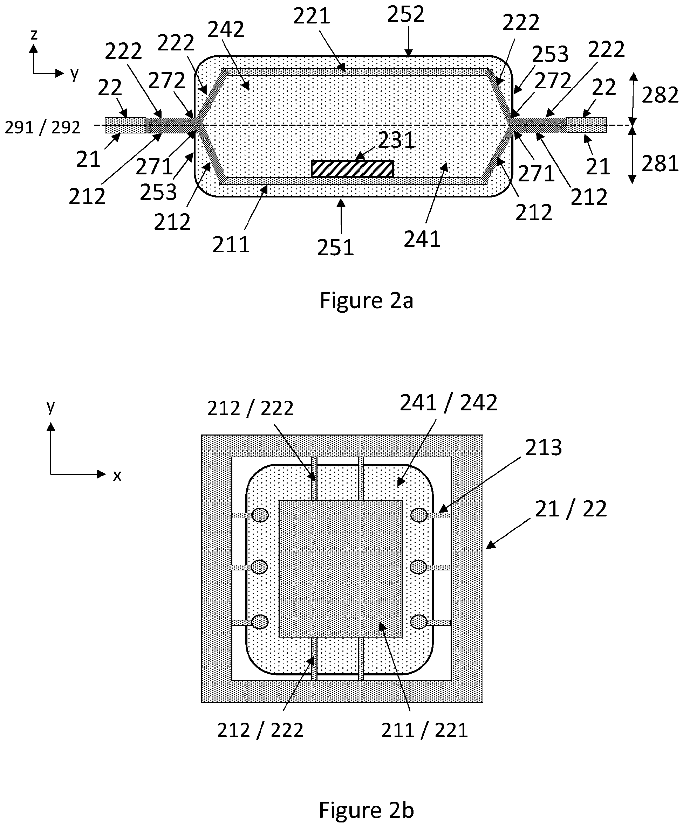

Figure 2a illustrates a cross-section of an electronic component which comprises a plastic package 241 / 242 which surrounds a die pad 211 and an opposing pad 221. A first electric chip 231 is attached to the die pad. The illustrated component is still attached to the first and second leadframes 21 and 22 in figures 2a and 2b. The first and second leadframes 21 and 22 define a first support plane 291 and a second support plane 292, respectively, which here coincide and are illustrated as the xy-plane. The z-direction is the vertical direction which is perpendicular to the xy-plane. The die pad 211 and opposing pad 221 are offset in the vertical direction on opposite sides of the xy-plane. A first support structure 212 connects the die pad 211 to the first leadframe 21. A second support structure 222 connects the opposing pad 221 to the second leadframe 22. The package has a first surface 251, a second surface 252 and side surfaces 253. Throughout this disclosure, the at least one side surface will be illustrated as two side surfaces which are opposed to each other in a horizontal direction which is perpendicular to the vertical direction like surfaces 253 in figure 2a. However, the component may in practice have for example four side surfaces, and the support structures which are attached to one pad (the die pad or the opposing pad) may be connected to support points on one, two, three or four of these side surfaces.

Figure 2b illustrates the first or the second leadframe 21 and 22 in the xy-plane before the die pad 211 / the opposing pad 221 and the support structures 212 / 222 are offset from the plane defined by the leadframe in the z-directions which figure 2a illustrates. After the offset step, where the support structures 212 / 222 may be bent, the support structures 212 / 222 hold the corresponding pads 211 / 221 in place at the desired distance from the xy-plane until the pads are embedded in the plastic mould illustrated as 241 / 242 in figure 2b. The support structures also provided structural support inside the finished component.

The support structures 212 / 222 may be narrow tie bars as figure 2b illustrates which extend in a first direction (the y-direction in figure 2b) from the main body of the leadframe (represented as the frame 21 / 22 in figure 2b) to the die pad 211 or to the opposing pad. The width of a tie bar 212 / 222 in the direction which is perpendicular to the first direction may for example be less than 50%, less than 20% or less than 5% of the width of the corresponding pad 211 / 221 in the same direction. These options apply in all embodiments presented in this disclosure.

Alternatively, the support structures could be wider than figure 2b illustrates. The number of support structures connected from one pad (211 or 221) to one side surface 253 may for example be in the range 1 - 10. Although support structures are illustrated on both side of the pads 211 / 221 in figure 2b, it may sometimes be sufficient to use support structures 212 / 222 which are connected only to one side surface. These options apply in all embodiments presented in this disclosure.

In all embodiments of this disclosure, the point where the first support structure 212 reaches the outer surface of the sidewall 253 of the plastic package is called a first support point 271. The point where the second support structure 272 reaches the outer surface of the sidewall 253 of the plastic package is correspondingly called a second support point 272. When the package is released from the leadframe, the support structures may be cut off at these support points 271 / 272 so that the support structures do not extend to the exterior of the package (in other words, the parts of the leadframe 21 / 22 which extends to the exterior of the package in figure 2a would be removed). However, it is also possible that one or both of the support structure is cut off from the leadframe at a distance from the package wall, so that a part of the support structure extends outward from the outer surface of the package sidewall 253. In that case the first and second support points 271 - 272 are still defined the points where the support structures reach the outer surface of the sidewall.

In all embodiments of this disclosure, the plane defined by the first leadframe 21 during the manufacturing process defines the vertical coordinate of the first support point 271 and thereby the first support plane 291. Correspondingly, the plane defined by the second leadframe 22 during the manufacturing process defines the vertical coordinate of the second support point 272 and thereby the second support plane 292. In other words, until the overmolded plastic package is released from the first and second leadframes, the first support point 271 lies within the plane of the first leadframe 21 and the second support point 272 lies within the plane of the second leadframe 22. However, as will be explained in more detail below, the first and second support plane are not necessarily always the same plane, as they are in figure 2a.

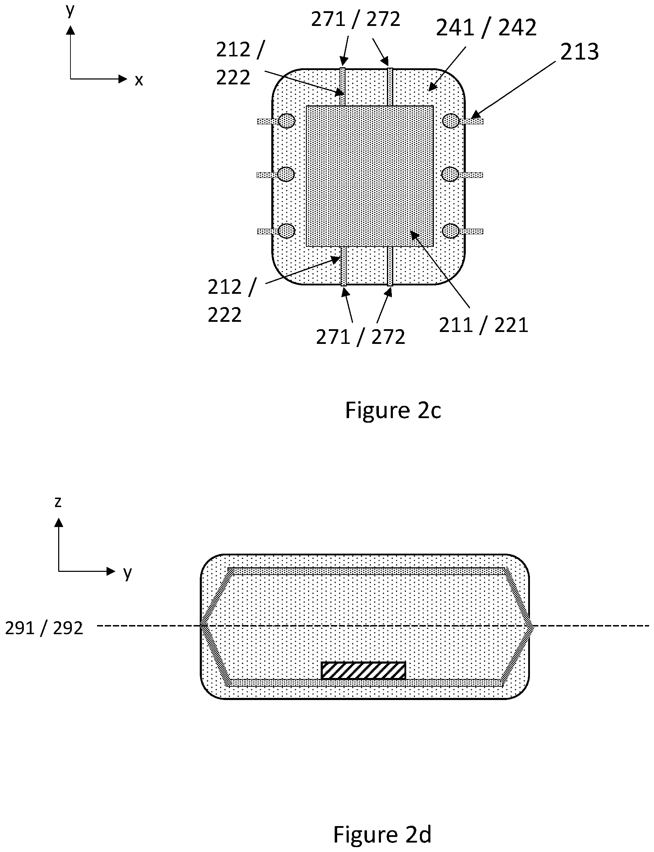

As mentioned above, the contact elements 213 illustrated in figure 2b are typically cut off from the main part of the leadframe at a suitable distance from the package wall so that they extend to the exterior of the package. They can thereby be easily connected to an electric circuit when the finished component is mounted on a circuit board. Figure 2c illustrates how the component could look in an xy-projection after it has been released from the first and second leadframes. Figure 2d illustrates a zy cross-section of the released component. The die pad and the opposing pad may both be inside the plastic package, as figure 2d illustrates.

The first half 241 of the package forms the first surface 251, which is illustrated as the bottom surface in figure 2a. The second half 242 of the package forms the second surface 252, which is illustrates as the top surface. However, either of these surfaces could face toward the circuit board where the component is mounted. These options apply in all embodiments presented in this disclosure.

The illustrated xy-plane may be parallel to a plane where the electronic component is intended to be attached, for example the plane of a circuit board. Words such as "bottom" and "top" refer in this disclosure only to two sides which are separated from each other in the z-direction. They do not refer how the component is intended to be placed on a circuit board - the either "top" or the "bottom" side could be attached to the circuit board. Also, words such as "bottom", "top", "vertical" and "horizontal" do not refer to the orientation of the component with regard to the direction of earth's gravitational field either when the component is manufactured or when it is in use.

The electronic chip 231 may be attached to the die pad 211 for example with an adhesive. The electric contacts of the electric chip 231 may be attached to the internal parts of contact elements 213 for example with by wire bonding. These options apply in all embodiments presented in this disclosure.

The first and second leadframes 21 and 22 (and the pads, support structures and contact elements which are produced from these leadframes) can be made of metal, for example copper or any other malleable metal. The pattern illustrated in figure 2b, which comprises the die pad or opposing pad 211 / 221, tiebars 212 / 222 which extend from the pad 211 / 221 to the main part of the leadframe 21 / 22 (illustrated as a frame in figure 2b) and contact elements 213, may be formed in the leadframe 21 / 22 for example by etching or stamping. Selected parts of the pattern, such as the die pad and the opposing pad, may then be offset from the plane defined by the corresponding leadframe in the z-direction with a downset tool which pushes and bends these parts out of the xy-plane. These manufacturing options apply in all embodiments presented in this disclosure.

The first support structures 212 extend from the main part of the first leadframe 21 to the die pad 211 and keep the die pad firmly attached to the first leadframe 21 until the package 241 / 242 is moulded over the leadframe. Correspondingly, the second support structures 222 extend from the main part of the second leadframe 22 to the opposing pad 221 and keep the opposing pad firmly attached to the second leadframe 22. As mentioned above, at least one first support structure is needed to support the die pad during the overmolding process, and at least one second support structure is needed to support the opposing pad. The first and second support structures 212 / 222 will then remain inside the component when the package is released from the first and second leadframes 21 / 22, providing a symmetric and rigid support structure in the top and bottom halves of the component. These options apply in all embodiments presented in this disclosure.

The z-coordinate of the die pad plane may be less than the z-coordinate of the first support plane 291, and the z-coordinate of the first support plane 291 may be substantially equal to the z-coordinate of the second support plane 292. Furthermore, the z-coordinate of the opposing pad plane may be greater than the z-coordinate of the second support plane 292, as figure 2a illustrates.

The difference (281) between (I) the z-coordinate of the die pad 211 and the z-coordinate of the first support plane 291 may be equal to the difference (282) between (II) the z-coordinate of the opposing pad 221 and the z-coordinate of the second support plane 292. However, the distances 281 and 282 could alternatively be unequal.

The first and second halves of the plastic package which are moulded onto the bottom side of the first leadframe and the top side of the second leadframe, respectively, may fill the inside of the component so that all elements of the component are embedded in the plastic material. Alternatively, the mould may be designed to leave a cavity inside the component. This cavity may be filled with a gas which surrounded the component during the moulding, for example air or any other suitable gas. The support structures can be embedded in the sidewalls of the plastic package if a cavity is present and also if a cavity is not present.

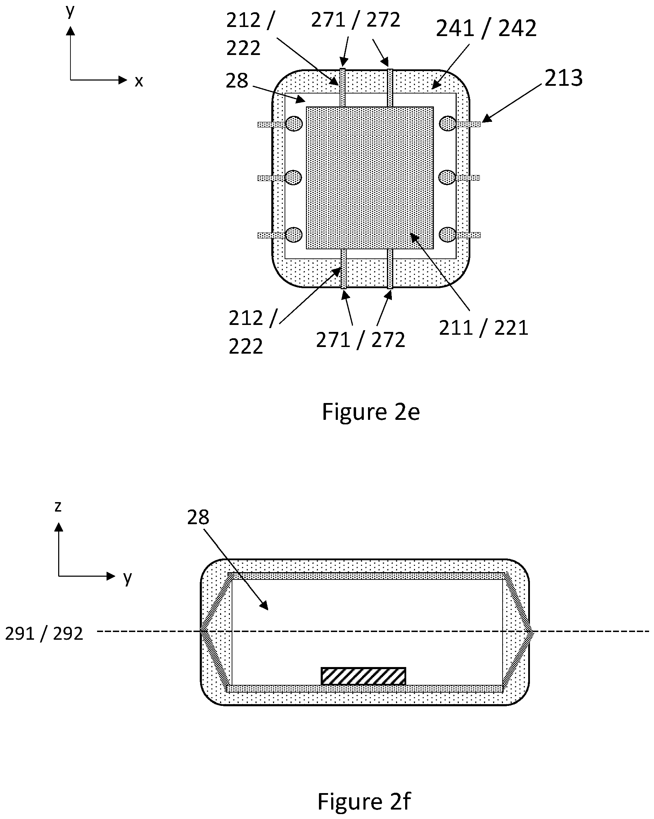

Figure 2e illustrates the same device as figure 2c with a cavity 28. Figure 2f illustrates the cavity 28 in a yz cross-section. The cavity 28 may extend from the surface of the die pad to the surface of the opposing pad, but any other height can also be chosen. One or both pads could be fully embedded in the plastic package even when a cavity 28 is present.

Alternatively, one or both pads could be located within the cavity so that neither of its surfaces is in contact with the plastic package. Cavities are not illustrated in the other figures presented in this disclosure, but all options mentioned in this paragraph can be implemented in any embodiment presented in this disclosure.

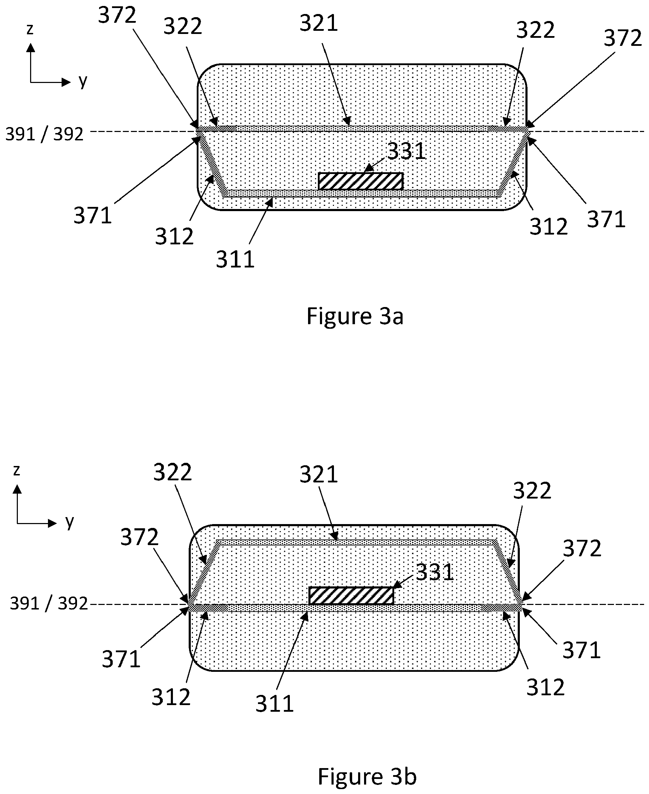

Figure 3a illustrates an alternative option where reference numbers 311 - 312, 321 - 322, 331, 371 - 372 and 391 - 392 correspond to reference numbers 211 - 212, 221 - 222, 231, 271 - 272 and 291 - 292, respectively, in figure 2a (after the component has been released from the leadframe, as in figure 2d). In figure 3a the z-coordinate of the die pad plane is again less than the z-coordinate of the first support plane 391, and the z-coordinate of the first support plane 391 is substantially equal to the z-coordinate of the second support plane 392. However, in this case, the z-coordinate of the opposing pad plane is equal to the z-coordinate of the second support plane 392. In other words, the opposing pad 321 has not been offset in the vertical direction from the plane defined by the second leadframe. The die pad, however, has been offset from the plane defined by the first leadframe.

The structure can also be turned around the other way, as figure 3b illustrates. the z-coordinate of the die pad plane may be equal to the z-coordinate of the first support plane 391, and the z-coordinate of the first support plane 391 may be substantially equal to the z-coordinate of the second support plane 392. The z-coordinate of the opposing pad plane may be greater than the z-coordinate of the second support plane 392. In this case the die pad has not been offset from the plane defined by the first leadframe, but the opposing pad has been offset from the plane defined by the second leadframe.

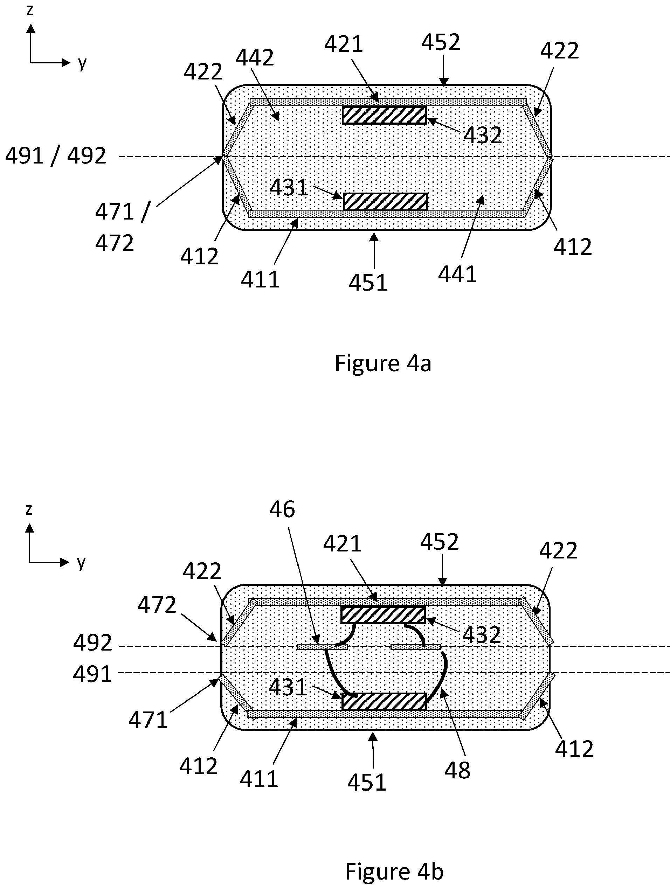

Figures 4a - 4b illustrate an electrical component where reference numbers 411 - 412, 421 - 422, 431, 441 - 442, 451 - 452, 471 - 472, 491 and 492 correspond to reference numbers 211 - 212, 221 - 222, 231, 241 - 242, 251 - 252, 271 - 272, 291 and 292, respectively, in figure 2a (after the component has been released from the leadframe, as in figure 2d). The component also comprises a second electric chip 432 which is attached to the opposing pad, and the first support point 471 is joined to the second support point 472 so that the first support structure 412 is in electrical contact with the second support structure 422. The electrical contact may be achieved simply be putting the at least one die pad tiebar in physical contact with the at least one opposing pad tiebar. Alternatively, a conductive solder material (for example tin), conductive coating (for example a layer of silver) or conductive glue may be applied at the interface between these two tiebars to facilitate a reliable electrical contact.

In figure 4a the first and second electric chips 431 - 432 may be electrically connected to the first support structure 412 and to the second support structure 422 which are in electrical contact with each other. An electric circuit which comprises both the first and the second electric chip can thereby be formed within the component. This may in some cases facilitate substantial reductions in the size of the component.

A component can also be placed on the opposing pad 4 in any other embodiment presented in this disclosure, even when the first and second support planes do not coincide. Figure 4b illustrates an alternative where additional contact structures 46 are formed from a leadframe. These additional contact structures may be formed from the first leadframe, the second leadframe or from both leadframes. They could be placed on any side surface of the package and they may extend to the outer side of the package, or they may extend only to the inner side of the package without extending to its outer side. The additional contact structures may be detached from the support structures in the finished package. If they are formed from the second leadframe, they can optionally be joined to contact elements, such as 213 in figure 2c, formed from the first leadframe.

The chips 431 and 432 may be connected to each other via these additional contact structures 46, for example by connecting each chip to an additional contact structure 46 with a wire bond 48. The number of electrical connections between the two chips can thereby be made greater than in figure 4a where no additional contact structures are present. The option shown in figure 4b can be combined with any other embodiment presented in this disclosure.

The first support point can be joined to the second support point so that the first support structure is in electrical contact with the second support structure even when no second electric chip is present in the device, for example for electromagnetic shielding purposes as described below.

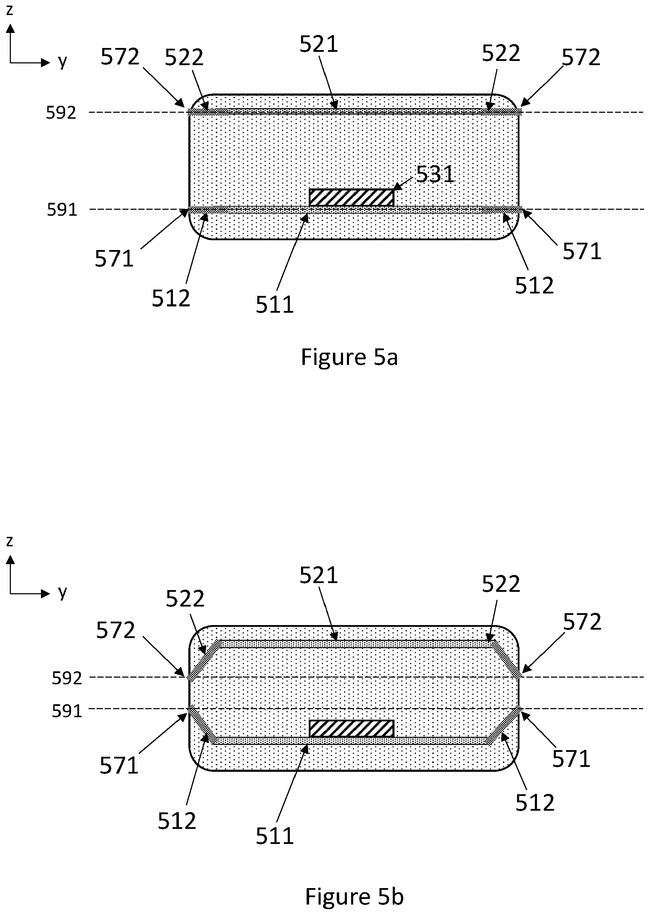

Figure 5a illustrates a component where reference numbers 511 - 512, 521 - 522, 531, 571 - 572 and 591 - 592 correspond to reference numbers 211 - 212, 221 - 222, 231, 271 - 272 and 291 - 292, respectively, in figure 2a (after the component has been released from the leadframe, as in figure 2d). In figure 5a the z-coordinate of the die pad plane is equal to the z-coordinate of the first support plane 591, and the z-coordinate of the first support plane 591 is less than the z-coordinate of the second support plane 592, and the z-coordinate of the opposing pad plane is equal to the z-coordinate of the second support plane 592. In other words, the first and the second support plane do not coincide. The die pad 511 and the first support structure 512 are instead in figure 5a located on one side of the component, the opposing pad 521 and the second support structure 522 are located on another side of the component. The first and second support planes 591 and 592 could have any suitable z-coordinates, and they could even both lie on the same side of the component. Both of them could for example be above or below a horizontal line which crosses the component at its vertical center point

Figure 5b illustrates an alternative option where the z-coordinate of the die pad plane is less than the z-coordinate of the first support plane 591, the z-coordinate of the first support plane 591 is less than the z-coordinate of the second support plane 592, and the z-coordinate of the second support plane 592 is less than the z-coordinate of the opposing pad plane. Another alternative which has not been illustrated is that the z-coordinate of the first support plane could be less than the z-coordinate of the die pad plane, the z-coordinate of the die pad plane could be less than the z-coordinate of the opposing pad plane, and the z-coordinate of the opposing pad plane could be less than the z-coordinate of the second support plane.

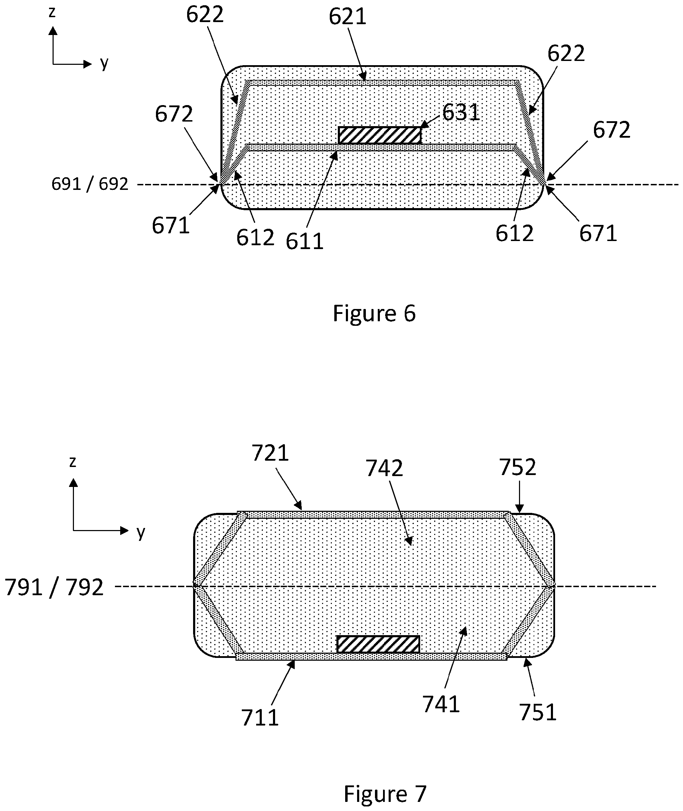

Figure 6 illustrates another option where where reference numbers 611 - 612, 621 - 622, 631, 671 - 672 and 691 - 692 correspond to reference numbers 211 - 212, 221 - 222, 231, 271 - 272 and 291 - 292, respectively, in figure 2a (after the component has been released from the leadframe, as in figure 2d). In figure 6 the z-coordinate of the first support plane 691 is equal to the z-coordinate of the second support plane 692, and the z-coordinate of the die pad plane is greater than the z-coordinate of the first support plane 691, and the z-coordinate of the opposing pad plane is greater than the z-coordinate of the die pad plane.

Another alternative is that the z-coordinate of the first support plane is equal to the z-coordinate of the second support plane, and the z-coordinate of the opposing pad plane is less than the z-coordinate of the second support plane 691, and the z-coordinate of the die pad plane is less than the z-coordinate of the opposing pad plane. This option has not been separately illustrated.

In any embodiment illustrated in this disclosure, the size and geometry of the die pad may be substantially equal to the size and geometry of the opposing pad, and the die pad may be substantially aligned with the opposing pad in the vertical direction. The stabilizing effect provided by a substantially symmetric opposing pad will typically be better than that which can be achieved with an opposing pad whose size or geometry differs significantly from that of the die pad. Nevertheless, an opposing pad of any size and geometry may provide some degree of stabilization to the component.

Figure 7 illustrates an alternative option where reference numbers 711, 721, 741 - 742, 751 - 752 and 791 - 792 correspond to reference numbers 211, 221, 241 - 242, 251 - 252 and 291 - 292, respectively, in figure 2a (after the component has been released from the leadframe, as in figure 2d). In figure 7 the die pad 711 is exposed on the first surface 751 of the package and the opposing pad 721 is exposed on the second surface 752 of the package. A pad which is exposed extends to the outside surface of the component. The vertical offsets of these pads from the first and second support planes 791 and 792 are in this case greater than the depth of the corresponding moulding tool from these planes. Alternatively, only one of these pads could be exposed while the other could be embedded in the package. An exposed pad can for example be attached to the surface of a circuit board when the component is mounted, which may reduce the effect that package resonance vibrations have on the operation of the chip. Exposed pads may also be used for heat conduction and/or for electrical contacting.

The first support plane and the second support plane may lie substantially in the middle of component in the z-direction. The vertical offset from the first support plane to the die pad may be equal to the vertical offset from the second support plane to the opposing pad. However, these offsets do not necessarily have to be equal.

The first and second leadframes 21 and 22 are illustrated as being stacked upon each other at the in figure 2a. However, the first and second leadframes could alternatively be shaped so that they can be placed next to each other, whereby they fit together like two pieces of a puzzle. The leadframes would then interlace in the xy-plane so that neither leadframe would be on top of the other.

In any embodiment described in this disclosure, the die pad and the opposing pad may both function as shields against electromagnetic radiation. The opposing pad and/or the die pad may be set to ground potential. If at least one die pad tiebar is in electrical contact with at least one opposing pad tiebar, both the opposing pad and the die pad may be grounded by connecting either of them to ground potential.

A method for manufacturing an electronic component described in this disclosure comprises at least the following steps:
manufacturing an electric chip; preparing a metallic die pad and a metallic first support structure in a first leadframe so that the die pad is connected with the first support structure to the main part of the first leadframe, wherein the die pad defines a die pad plane and the first leadrame defines a first support plane; attaching the electric chip to the die pad;
preparing a metallic opposing pad and a metallic second support structure in a second leadframe so that the opposing pad is connected with the first support structure to the second leadframe, wherein the opposing pad defines an opposing pad plane and the second leadframe defines a second support plane;
placing the first and second leadframes on top of each other or next to each other so that the die pad and the opposing pad are at least partly aligned with each other in the direction which is perpendicular to the die pad plane;
moulding a first half of a plastic package onto the bottom side of said first leadframe and moulding a second half of a plastic package onto the top side of said second leadframe so that the first and second support structures are at least partly embedded within the package;
releasing the first support structure from the first leadframe and releasing the second support structure from the second leadframe.

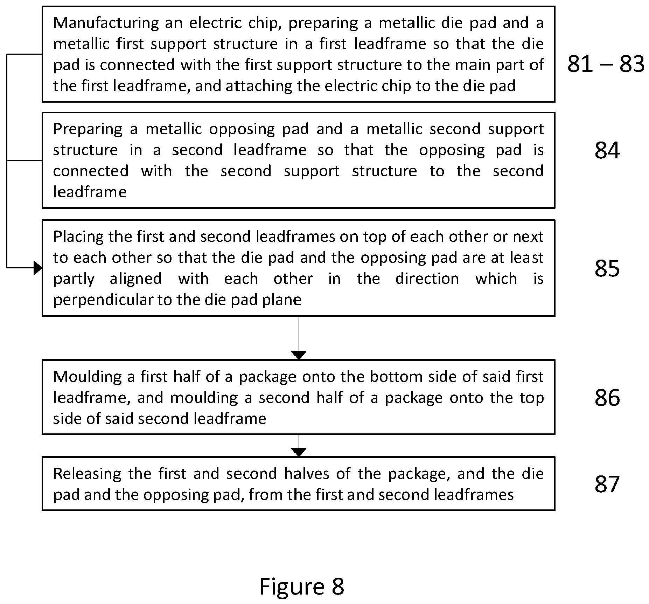

Figure 8 illustrates the steps of the method. The steps 81 - 84, which involve the manufacturing of the electric chip, the first leadframe and the second leadframe as separate parts, do not necessarily have to be performed in the order presented above - any order could be used. Once the first and the second leadframe have been put together in the fifth step 85, the sixth and seventh steps 86 - 87 are performed in the order indicated above.

The first leadframe may have a bottom side and a top side, and the die pad may be offset from the main part of the first leadframe in the vertical direction which extends away from its bottom side. The second leadframe may also have a bottom side and a top side, and the opposing pad may be offset from the main part of the second leadframe in the vertical direction which extends away from its top side. If the first and second leadframes are placed on top of each other, the bottom side of the second leadframe may be placed on the top side of the first leadframe.

The main part of each leadframe is formed by the parts of the planar leadframe sheet which surround the die pad, opposite pad, support structure and contact element patterns. These main parts define the surface which will form the support plane in the component. These main parts are illustrated as a frame in figure 2b, but they may in practice extend far beyond these patterns. Multiple components may be manufactured from both leadframes, and the leadframes may thereby comprise multiple patterns like the one shown in figure 2b, arranged in an array.

When the first and second leadframes are placed on top of each other, they are arranged in the manner illustrated in figures 2a, for example. Alternatively, when they are placed next to each other, they may be interlaced like the pieces of a puzzle, as explained above. In the figures of this disclosure, the die pad has been illustrated at the bottom of the device and the opposing pad at the top. However, the component can be mounted on a circuit board either with the die pad facing the circuit board or with the opposing pad facing the circuit board.

A moulding tool may be placed over the leadframe when the first and second halves of the package are formed on the respective leadframes. The tool is filled with molten plastic, which is then solidified. Both halves of the package may be moulded simultaneously, or either half may be molded before the other.

Figures 2a, 2d, 3a, 3b, 4a - 4b and 5a - 5b illustrate embodiments where the die pad and the opposing pad are embedded within the moulded plastic package so that the first and second surfaces of the package form the entire bottom surface and top surface of the entire component. The vertical offset (if any) of the die pad / opposing pad from the plane of the leadframe is in these examples less than the vertical depth of the moulding tool which is used to form the corresponding half of the package. In figure 7, on the other hand, the vertical offset of the die pad 711 and the opposing pad 721 was slightly greater than the depth of the moulding tool so that the die pad and the opposing pad are exposed. In other words, the die pad and the opposing pad may be embedded within the plastic package. Alternatively, one or both of them may be partly embedded in the plastic package so that one side of the pad is embedded while the other one is exposed.

All options described above with reference to figures 2a - 7 and all options relating to the z-coordinates of the die pad plane, the opposing pad plane and the first and second support planes apply also to the method illustrated in figure 8. The method may also comprise the step of attaching a second electric chip to the opposing pad. Furthermore, the method may comprise the step of joining the first support point to the second support point so that the first connecting structure is in electrical contact with the second connecting structure. The first half of the package may be moulded so that the die pad is exposed on the first surface of the package. The second half of the package may be moulded so that the opposing pad is exposed on the second surface of the package.

## Claims

1. An electronic component comprising a plastic package and an electric chip which is inside the package, wherein the plastic package has a first surface and a second surface, and the first surface and second surface are opposite to each other in a vertical z-direction, and the plastic package has at least one side surface which extends between the first surface and the second surface,
and the electronic component comprises a metallic die pad which defines a die pad plane which is substantially horizontal, and a metallic first support structure extends from the die pad to a first support point on the at least one side surface of the plastic package, wherein the first support structure is at least partly embedded within the plastic package, and the z-coordinate of the first support point defines a horizontal first support plane, and a first electric chip is attached to the die pad,
**characterized in that** the electronic component also comprises a metallic opposing pad which defines an opposing pad plane which is substantially horizontal, and a metallic second support structure extends from the opposing pad to a second support point on the at least one side surface of the plastic package, wherein the second support structure is at least partly embedded within the plastic package, and the z-coordinate of the second support point defines a horizontal second support plane.

2. An electronic component according to claim 1, **characterized in that** the z-coordinate of the die pad plane is less than the z-coordinate of the first support plane, and the z-coordinate of the first support plane is substantially equal to the z-coordinate of the second support plane.

3. An electronic component according to claim 2, **characterized in that** the z-coordinate of the opposing pad plane is greater than the z-coordinate of the second support plane.

4. An electronic component according to claim 3, **characterized in that** the difference between (I) the z-coordinate of the die pad and the z-coordinate of the first support plane is equal to the difference between (II) the z-coordinate of the opposing pad and the z-coordinate of the second support plane.

5. An electronic component according to claim 2, **characterized in that** the z-coordinate of the opposing pad plane is equal to the z-coordinate of the second support plane.

6. An electronic component according to claim 1, **characterized in that** the z-coordinate of the die pad plane is equal to the z-coordinate of the first support plane, and the z-coordinate of the first support plane is substantially equal to the z-coordinate of the second support plane, and the z-coordinate of the opposing pad plane is greater than the z-coordinate of the second support plane.

7. An electronic component according to any of claims 1 - 6, **characterized in that** a second electric chip is attached to the opposing pad and the first support point is joined to the second support point so that the first support structure is in electrical contact with the second support structure.

8. An electronic component according to claim 1, **characterized in that** the z-coordinate of the die pad plane is equal to the z-coordinate of the first support plane, and the z-coordinate of the first support plane is less than the z-coordinate of the second support plane, and the z-coordinate of the opposing pad plane is equal to the z-coordinate of the second support plane.

9. An electronic component according to claim 1, **characterized in that** the z-coordinate of the first support plane is equal to the z-coordinate of the second support plane, and the z-coordinate of the die pad plane is greater than the z-coordinate of the first support plane, and the z-coordinate of the opposing pad plane is greater than the z-coordinate of the die pad plane.

10. An electronic component according to any of claims 1 - 9, **characterized in that** the size and geometry of the die pad is substantially equal to the size and geometry of the opposing pad, and the die pad is substantially aligned with the opposing pad in the vertical direction.

11. An electronic component according to any of claims 1 - 10, **characterized in that** the die pad is exposed on the first surface of the package.

12. An electronic component according to any of claims 1 - 11, **characterized in that** the opposing pad is exposed on the second surface of the package.

13. A method for manufacturing an electronic component, wherein the method comprises the steps of:
- manufacturing an electric chip,
- preparing a metallic die pad and a metallic first support structure in a first leadframe so that the die pad is connected with the first support structure to the main part of the first leadframe, wherein the die pad defines a die pad plane and the first leadrame defines a first support plane,
- attaching the electric chip to the die pad,
**characterized in that** method also comprises the steps of
- preparing a metallic opposing pad and a metallic second support structure in a second leadframe so that the opposing pad is connected with the second support structure to the second leadframe, wherein the opposing pad defines an opposing pad plane and the second leadframe defines a second support plane,
- placing the first and second leadframes on top of each other or next to each other so that the die pad and the opposing pad are at least partly aligned with each other in the direction which is perpendicular to the die pad plane,
- moulding a first half of a plastic package onto the bottom side of said first leadframe and moulding a second half of a plastic package onto the top side of said second leadframe so that the first and second support structures are at least partly embedded within the package,
- releasing the first support structure from the first leadframe and releasing the second support structure the second leadframe.

14. A method according to claim 13, **characterized in that** the die pad is exposed on the first surface of the package.

15. A method component according to any of claims 13 - 14, **characterized in that** the opposing pad is exposed on the second surface of the package.
